# EUROPEAN PATENT APPLICATION

(11) **EP 4 669 046 A1**
(43) Date of publication of application: **24.12.2025**
(21) Application number: 25181915.7
(22) Date of filing: 10.06.2025
(51) Int. Cl.: H05K 7/20

(54) **OPTIMIZED AIRFLOW MANAGEMENT SYSTEM FOR REDUNDANT FANS**

(30) Priority: 20.06.2024 IN 202421047544; 02.06.2025 US 202519255625
(71) Applicant: Vertiv Corporation, Westerville, OH 43082 (US)
(72) Inventor: NATARAJAN, Srinivasan, Westerville, 43082 (US); PAITHANE, Manoj, Westerville, 43082 (US); NICHIT, Rohit, Westerville, 43082 (US); SURVASE, Tushar, Westerville, 43082 (US)
(74) Representative: Bryn-Jacobsen, Caelia

(57) **Abstract**

An apparatus for airflow management within a static transfer switch (STS) or like air-cooled cabinet-based device includes a structure for preventing airflow leakage (e.g., secondary airflow) via a redundant or backup fan capable of replacing a failed primary fan, but which is not operational while the primary fans are functioning, e.g., providing a primary airflow into and through the device for heat transfer. The structure attaches to and covers the fan when in a closed formation, preventing primary airflow directed through the device from leaking through the fan as secondary airflow. When the covered fan is operational, the resulting primary airflow pressure deploys the structure into an open formation, where the primary airflow may be freely directed into or through the cabinet-based device, e.g., by the active fan.

## Description

### CROSS-REFERENCE TO RELATED APPLICATIONS

This application claims priority under 35 USC § 365 to prior filed Indian provisional patent application 202421047544 filed June 20, 2024.

### TECHNICAL FIELD

The present invention generally relates to thermal management systems, and more particularly to airflow management for static transfer switches (STS) and other cabinet-based devices.

### BACKGROUND

The background information herein below relates to the present disclosure but is not necessarily prior art.

Redundant fans are employed in electronics and computing environments to enhance reliability and ensure continuous operation, especially in critical systems. Their primary importance lies in providing a backup in case the primary fan fails, preventing overheating and potential system failure. This feature is crucial in environments where uptime is critical, such as data centers, servers, and industrial equipment. In mission-critical applications, even a short downtime can lead to significant losses. Redundant fans ensure continuous cooling, allowing systems to stay operational. Maintaining optimal temperature conditions also helps extend the lifespan of electronic components by reducing thermal stress, leading to fewer breakdowns and longer service life.

The implementation of redundant fans involves several strategies. Many systems are designed with hot-swappable fan units, allowing for replacement without shutting down the equipment. This feature is particularly beneficial in servers and network equipment, where maintaining uptime is crucial. Advanced systems include monitoring mechanisms that detect fan failure and automatically activate the redundant fan. Software control can manage fan speed and operation based on temperature readings, optimizing performance and energy efficiency. In some configurations, multiple fans operate simultaneously but share the cooling load. If one fan fails, the remaining fans can ramp up to compensate.

Redundant fans are standard in several key applications. In data centers and servers, they prevent overheating of critical IT infrastructure, ensuring reliability and continuity of services crucial for cloud computing and online services. Telecommunication equipment often operates in environments with stringent uptime requirements, and redundant fans help meet these reliability standards. Industrial electronics, such as Programmable Logic Controllers (PLCs) and control panels, use redundant fans to ensure continuous operation in harsh environments. High-end consumer electronics, such as gaming consoles and high-performance PCs, may also incorporate redundant fans to enhance cooling and performance reliability.

In summary, the use of redundant fans in electronics is a critical design choice for enhancing reliability, maintaining uptime, and ensuring the longevity of components, especially in environments where continuous operation is paramount.

While redundant fans offer significant benefits in enhancing reliability and ensuring continuous operation in electronic systems, they can also present certain issues. One notable problem is that they can create pathways for air to escape from the area that needs to be cooled. This issue can undermine the cooling efficiency and effectiveness of the system.

Redundant fans, especially when not properly sealed or integrated, can create gaps through which cooled air can escape. This leakage reduces the overall cooling efficiency as the intended airflow pattern is disrupted. Air escaping through unintended pathways can lead to uneven cooling, with some components receiving insufficient airflow and others potentially being overcooled. The presence of multiple fans, if not well-coordinated, can lead to pressure imbalances within the system. If redundant fans are not synchronized, one fan might push air out faster than another, causing turbulence and inefficiency. Pressure imbalances can also exacerbate air leakage, as areas of higher pressure seek to equalize with areas of lower pressure, pushing air out through any available gaps.

### SUMMARY

In a first aspect, an apparatus for airflow management within a cabinet-based device or like environment is disclosed. In examples, the apparatus includes a structure attachable to a fan configured for directing air into and through the device or environment, e.g., for dissipating heat generated therein. The structure maintains a closed or undeployed formation when the fan is not operational, such that airflow through the fan is obstructed. When the fan is operational, the structure deploys into an open formation such that airflow through the fan is allowed.

In some examples, the fan has an inflow side and an outflow side, such that airflow is directed from the inflow to the outflow side. The structure is attached to the inflow side of the fan.

In some examples, the structure comprises left-side and right-side rigid portions connected by a rigid rear portion perpendicular to the left-side and right-side rigid portions, such that the left-side and right-side rigid portions are attached to the fan. Each of the left-side and right-side portions includes a hinged cutout portion attached to its respective rigid portion. For example, the cutout portions configured for pivoting or rotating to a closed formation perpendicular to the left-side and right-side rigid portions when the fan is not operational. Similarly, when the fan is operational and the apparatus in the open formation, the cutout portions remain parallel or coplanar to the rigid portions, e.g., held in place by air pressure.

In some examples, the structure is a deformable screen held in the closed formation when the fan is not operational, e.g., in a folded state, by springs, cams, and/or actuators, which transition the deformable screen to the open formation when the fan is operational.

In some examples, the structure is a deformable screen held in an expanded state when in the closed formation (e.g., and the fan is not operational) and contracts into the open formation when the fan is operational.

In some examples, the apparatus includes a flexible tubular structure attached to the outflow side of the fan, which stays in the closed formation, e.g., blocking airflow through the fan, when the fan is not operational, but is maintained by airflow in the open formation when the fan is operational.

In a further aspect, a cabinet-based device, e.g., a static transfer switch (STS) or like heat-generating device is disclosed. In examples, the cabinet-based device includes a set or array of fans for circulating air into and through the cabinet-based device, e.g., to remove heat generated therein. For example, the fan array includes one or more primary fans and one or more redundant or backup fans, for use when a primary fan fails. At least one fan of the array includes a structure attached thereto having a closed formation and an open formation. For example, the closed formation prevents airflow through the associated fan when the fan is not operational, e.g., when a backup fan is not in use and airflow directed by the primary fans may leak or bleed through the backup fan. Similarly, the open formation permits airflow through the fan, e.g., when a redundant or backup fan is engaged.

In some examples, the cabinet-based device includes at least one heat sink. For example, airflow through the device is directed over or through the heat sink to aid in heat absorption from the air, such that the absorbed heat may be dissipated outside the device.

In some examples, the structure is attached only to the one or more redundant fans.

In some examples, each fan has an inflow side and an outflow side, such that airflow is directed from the inflow side toward the outflow side. For example, each structure may be attached to the inflow side of its associated fan.

In some examples, each structure comprises left-side and right-side rigid portions connected by a rigid rear portion perpendicular to the left-side and right-side rigid portions, such that the left-side and right-side rigid portions are attached to the fan. Each of the left-side and right-side portions includes a hinged cutout portion attached to its respective rigid portion. For example, the cutout portions configured for pivoting or rotating to a closed formation perpendicular to the left-side and right-side rigid portions when the fan is not operational. Similarly, when the fan is operational and the apparatus in the open formation, the cutout portions remain parallel or coplanar to the rigid portions, e.g., held in place by air pressure.

In some examples, each structure is a deformable screen held in the closed formation when the fan is not operational, e.g., in a folded state, by springs, cams, and/or actuators, which transition the deformable screen to the open formation when the fan is operational.

In some examples, each structure is a deformable screen held in an expanded state when in the closed formation (e.g., and the fan is not operational) and contracts into the open formation when the fan is operational.

In some examples, the apparatus includes a flexible tubular structure attached to the outflow side of the fan, which stays in the closed formation, e.g., blocking airflow through the fan, when the fan is not operational, but is maintained by airflow in the open formation when the fan is operational.

It is to be understood that both the foregoing general description and the following detailed description are exemplary and explanatory only and are not necessarily restrictive of the present disclosure. The accompanying drawings, which are incorporated in and constitute a part of the specification, illustrate subject matter of the disclosure. Together, the descriptions and the drawings serve to explain the principles of the disclosure.

### OBJECTS

Some of the objects of the present disclosure, which at least one example herein satisfies, are as follows:
- To provide an optimized airflow management system for redundant fans;
- To mitigate the issue of air recirculation caused by redundant fans;
- To enhance airflow through the heat sink assembly by reducing air recirculation by preventing air from the operating fans from being drawn back into the intake through redundant fan openings;
- To enhance energy efficiency by reducing the workload on the operating fans;
- To potentially lower energy consumption and operational costs; and
- To offer cost-effective solutions that can be implemented with minimal additional costs or modifications to the existing STS assembly, leveraging simple mechanical principles.

Other objects and advantages of the present disclosure will be more apparent from the following description, which is not intended to limit the scope of the present disclosure.

### BRIEF DESCRIPTION OF THE ACCOMPANYING DRAWING

Examples of the inventive concepts disclosed herein will now be described with the help of the accompanying drawings, in which:
Figure 1 is a wireframe diagram providing an isometric of cabinet-based device incorporating primary fans and redundant fans according to examples of the disclosure;
Figure 2 is a top view of the cabinet-based device of Figure 1;
Figure 3 is a front view of the cabinet-based device of Figure 1; and
Figure 4A is an overhead view of structures for self-deploying airflow management for redundant fans of the cabinet-based device of Figure 1, in both open and closed formations, shown in detail by Figures 4B and 4C respectively, according to the inventive concepts disclosed herein;
Figure 5 is an overhead view of a structure for self-deploying airflow management for redundant fans of the cabinet-based device of Figure 1, according to the inventive concepts disclosed herein;
Figures 6A and 6C are forward views of structures for self-deploying airflow management for redundant fans of the cabinet-based device of Figure 1, in respectively closed or undeployed formations, according to the inventive concepts disclosed herein;
Figures 6B and 6D are forward views of the respective structures of Figures 6A and 6C in open or deployed formations, according to the inventive concepts disclosed herein; and
Figure 7 is a side view of a structure for self-deploying airflow management for redundant fans of the cabinet-based device of Figure 1, in an open formation, according to the inventive concepts disclosed herein.

### DETAILED DESCRIPTION

Examples, of the present disclosure, will now be described with reference to the accompanying drawings.

Examples are provided so as to thoroughly and fully convey the scope of the present disclosure to the person skilled in the art. Numerous details are set forth, relating to specific components, and methods, to provide a complete understanding of examples of the present disclosure. It will be apparent to the person skilled in the art that the details provided in the examples should not be construed to limit the scope of the present disclosure. In some examples, well-known processes, well-known apparatus structures, and well-known techniques are not described in detail.

The terminology used, in the present disclosure, is only for the purpose of explaining a particular example and such terminology shall not be considered to limit the scope of the present disclosure. As used in the present disclosure, the forms "a", "an", and "the" may be intended to include the plural forms as well, unless the context clearly suggests otherwise. The terms "comprises," "comprising," "including," and "having," are open ended transitional phrases and therefore specify the presence of stated features, operations, elements, modules, units and/or components, but do not forbid the presence or addition of one or more other features, operations, elements, components, and/or groups thereof.

When an element is referred to as being "mounted on", "engaged to", "connected to", or "coupled to" another element, it may be directly on, engaged, connected or coupled to the other element.

Terms such as "inner", "outer", "beneath", "below", "lower", "above", "upper", and the like, may be used in the present disclosure to describe relationships between different elements as depicted from the figures.

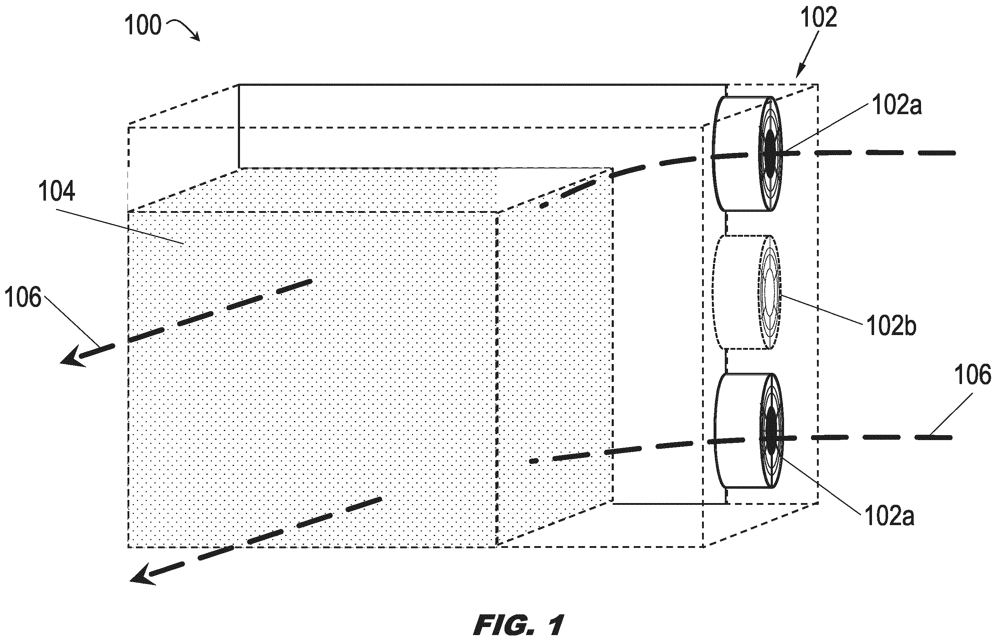

Referring generally to Figures 1 through 3, an optimized airflow management system for fans may be implemented in a Static Transfer Switch (STS) or any other appropriate type of cabinet-based device 100 incorporating air cooling via fans 102 and heat sink 104. For example, the cabinet-based device 100 may incorporate processors or other components within which are capable of generating heat. The heat must be removed from within the cabinet-based device 100 or optimal operation of the processors and/or components may be hindered or delayed due to unforeseen downtime.

In examples, the fans 102 circulate air into and through the cabinet-based device 100. For example, the airflow 106 (e.g., primary airflow) may be directed through the primary fans 102a, from an inflow side external to the cabinet-based device 100 to an inflow side within the cabinet-based device, across or proximate to any heat-generating interior components, and then over or through the heat sink 104.

In examples, the fans 102 may include primary fans 102a and redundant fans 102b (e.g., backup fans). For example, an array of fans 102 may include three fans, of which one, two, or all three may be operating depending on the level of heat transfer or removal desired or needed. Accordingly, one or two fans normally operational may be considered primary fans 102a, and any fans not normally operational may be considered redundant fans 102b. In examples, redundant fans 102b may become operational only upon failure of one or more primary fans 102a in order to maintain an optimal level of heat transfer.

In examples, when the primary fans 102a are normally operational, the primary airflow 106 may induce bleed and/or leakage 108 (e.g., secondary airflow). For example, a portion of the primary airflow 106 generated by the primary fans 102a within the cabinet-based device 100 may be circulated toward the dormant redundant fan 102b, and may leak or bleed therethrough as secondary airflow 108, in a direction opposite that of the primary airflow (e.g., from the outflow side of the redundant fan to the inflow side, and thereby outside the cabinet-based device 100). This secondary airflow 108 may adversely affect the cooling performance of the cabinet-based device 100, as the primary airflow 106 may not be optimally directed through the device and toward the heat sink 104. Further, a higher energy expenditure may be necessary to achieve a desired level of cooling performance, as quantified by internal temperatures inside the cabinet-based device 100.

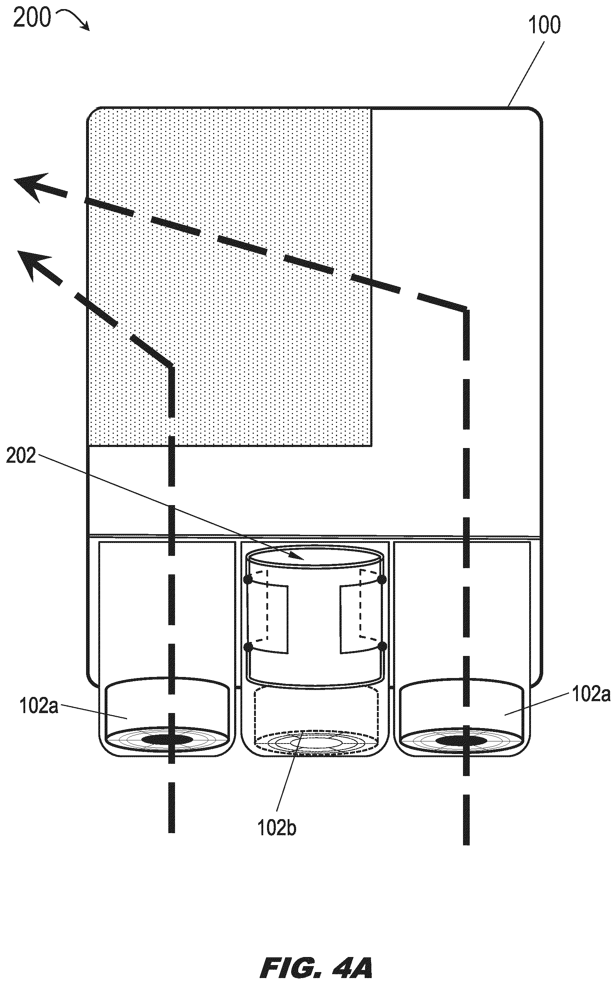

Referring now to Figures 4A through 4C, a self-activated damper system 200 can be introduced to mitigate air recirculation in the cabinet-based device 100. In examples, the self- activated damper system 200 may include a structure 202 attachable to one or more of the fans 102, e.g., to a redundant fan 102b not expected to operate during normal operations of the cabinet-based device 100. For example, the structure 202 may include left-side and right-side rigid members 202a, 202b fashioned of a rigid material. The structure 202 may further include a rear portion 202c attached to the left-side and right-side rigid members 202a, 202b and in a perpendicular orientation thereto. In some examples, e.g., when the structure 202 is substantially cylindrical or otherwise rounded, the left-side and right-side rigid members 202a, 202b may correspond to left-side and right-side halves or portions of the curved surface of the structure 202.

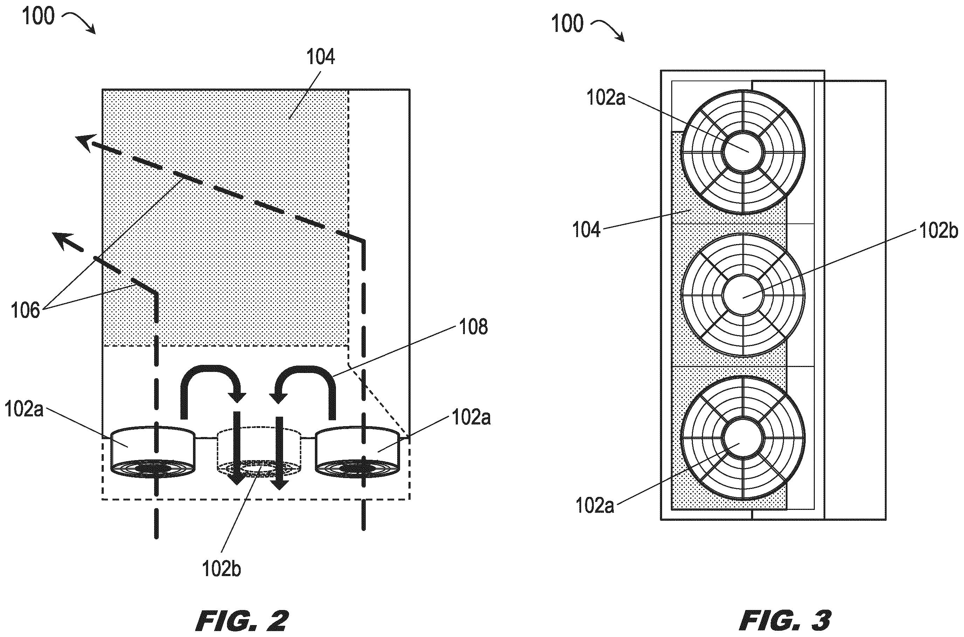

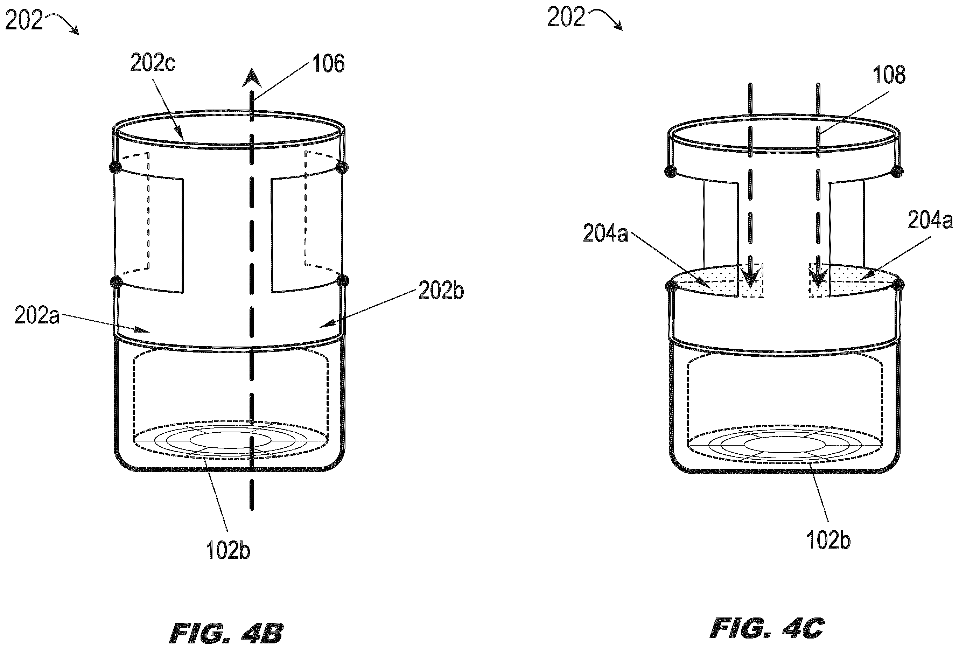

In examples, the left-side and right-side rigid members 202a, 202b may each include one or more cutout portions 204 set thereinto, each cutout portion fashioned from a similarly rigid but less air-permeable material. For example, when the redundant fan 102b (or primary fan 102a, see FIGS. 1-3) is operational, as shown by FIG. 4B, the primary airflow 106 created by the fan may maintain the cutout portions 204 in an open formation, substantially coplanar with or parallel to the left-side and right-side rigid portions 202a, 202b, allowing primary airflow 106 through the rear portion 202c. In examples, when the redundant fan 102b is not operational (as shown by FIG. 4C), the cutout portions 204 may be spring-loaded or otherwise attached to the structure 202 such that the cutout portions may retract 204a from the left-side and right-side rigid portions 202a, 202b into a closed formation. For example, when in the closed formation the retracted cutout portions 204a may block secondary airflow 108 through the redundant fan 102b (as shown by FIG. 4C). This ensures that the primary airflow 106 generated by the primary fans 102a (see FIGS. 1 and 2) is consistently directed over the heat sink (102), optimizing heat removal. The cutout portions 204 remains closed while the redundant fan 102b remains non-operational, causing air to be evenly distributed across the heat sink (104, FIG. 1) by blocking the redundant fan opening.

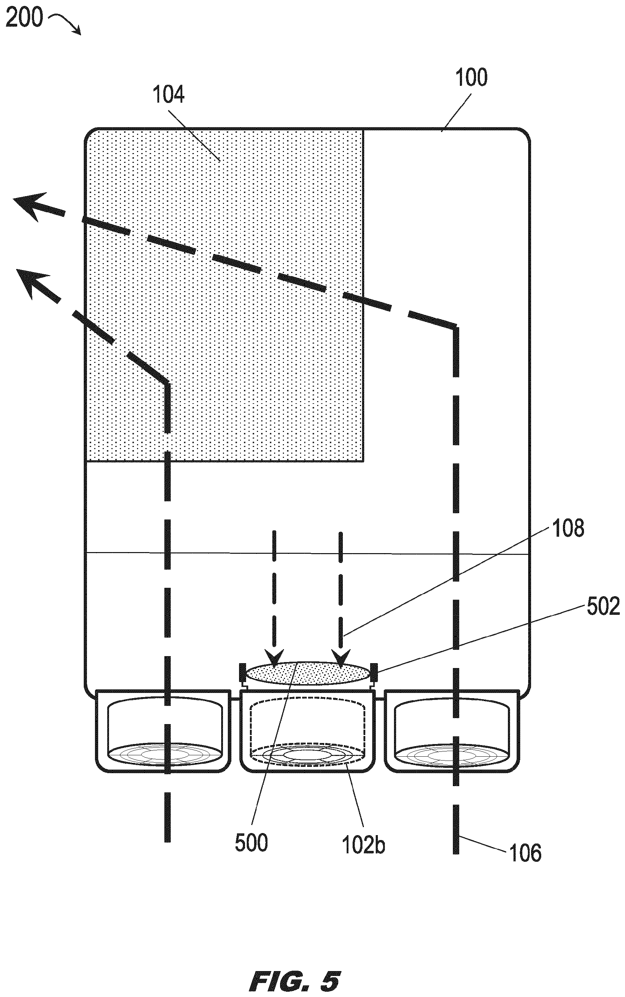

Referring now to FIG. 5, the cabinet-based device 100 and self-activated damper system 200 are shown.

In examples, the self-activated damper system 200 may include a deformable screen 500 disposed in front of the redundant fan 102b, e.g., on the outflow side of the fan within the cabinet-based device 100. For example, the deformable screen 500 may remain closed using cams, spring tensioning, and/or actuators 502 when the redundant fan 102b is inactive, thereby preventing airflow bypass or leakage 108. In examples, the screen mechanism may incorporate mechanical deformation held in the closed formation by spring tension or actuators, and it unfolds to the open formation when the redundant fan 102b is operational. This ensures no secondary airflow 108 through the redundant fan 102b, thus maintaining optimal primary airflow 106 through the heat sink 104 for effective cooling. In examples, when the redundant fan 102b is no longer operational, the deformable screen 500 reverts to the closed formation to restrict secondary airflow 108 from the redundant fan/s 102b, thus directing all primary airflow 106 towards the heat sink assembly 104.

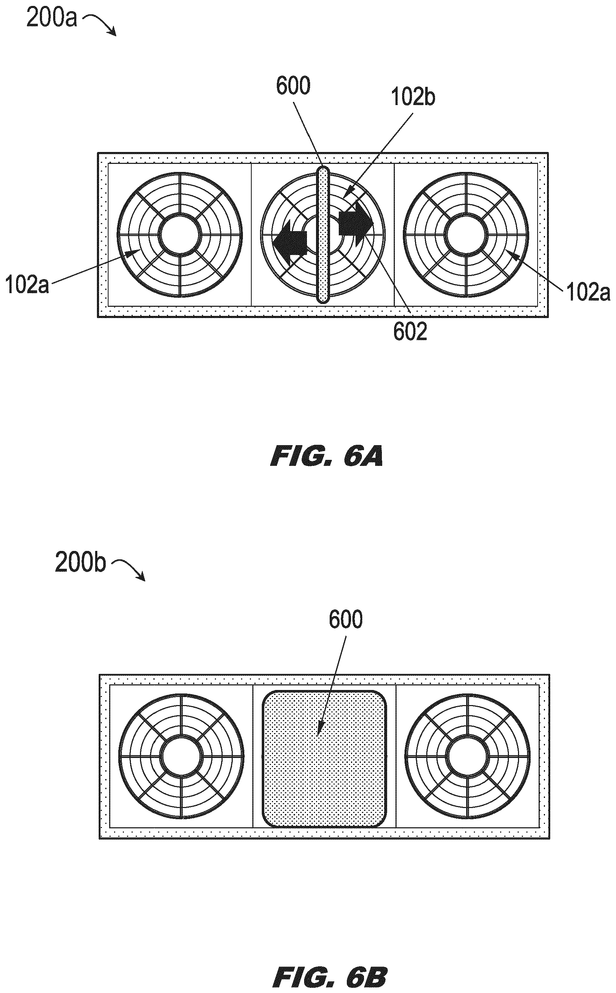

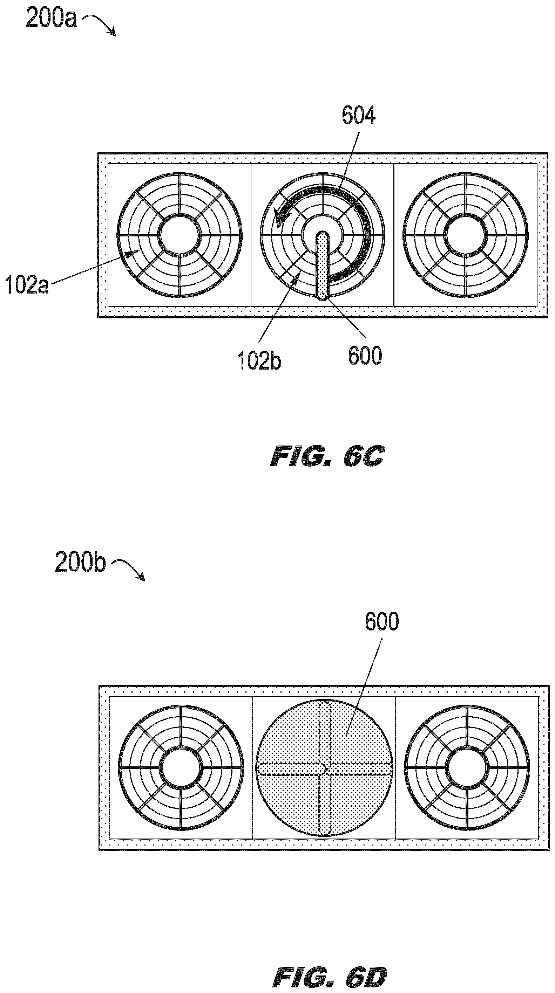

Referring now to FIGS. 6A through 6D, the self-activated damper system 200a, 200b is shown in the open formation (200a, FIGS. 6A and 6C) and closed formation (200b, FIGS. 6B and 6D) respectively.

In examples, the self-activated damper system 200 may incorporate a deformable barrier 600 capable of expanding into the closed formation 200b either in a linear fashion (602; see open formation 200a of FIG. 6A and closed formation 200b of FIG. 6B) or in a radial fashion (604; see open formation 200 of FIG. 6C and closed formation 200b of FIG. 6D) to cover the redundant fan 102b when said fan is not operational, and contracting back to the open formation 200a when the redundant fan is activated. For example, mechanisms such as cam, spring action, or actuators may facilitate the expansion and contraction of the deformable barrier 600. This method leverages the properties of deformable materials that can change shape under mechanical action, effectively acting as a dynamic barrier to air recirculation.

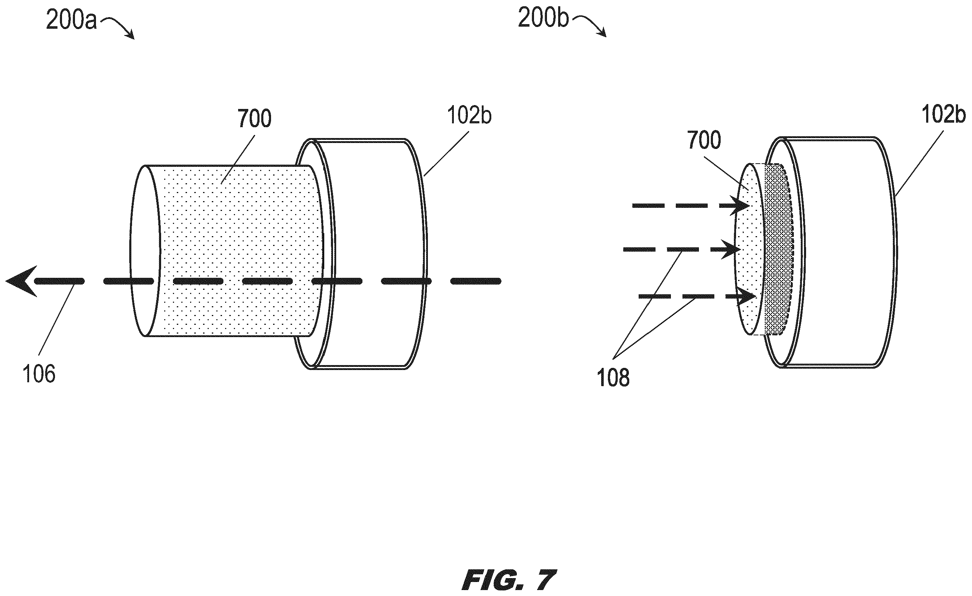

Referring now to FIG. 7, the self-activated damper system 200 is shown in open formation 200a and closed formation 200b.

In examples, the self-activated damper system 200 may incorporate a flexible tubular structure 700 configured for mounting in the airflow direction 106 of a redundant fan 102b, e.g., on the outflow side of the fan, within the cabinet-based device 100. For example, when in the open formation 200a (e.g., when the redundant fan 102b (or the primary fan 102a, see FIGS. 102) is operational), the tubular structure 700 may inflate to allow the airflow 106 to pass into and through the cabinet-based device 100. Similarly, when the redundant fan 102b is not operational and the tubular structure 700 may likewise deflate into the closed formation 200b to block airflow or leakage 108 through the non-operational redundant fan. In examples, the tubular structure 700 may self-deploy based on air pressure associated with the primary airflow 106 proximate to the redundant fan 102b, e.g., within a plenum duct area directly behind the fan on the outflow side. When, for example, the redundant fan 102b is deactivated, the lack of primary airflow 106 may cause the tubular structure 700 to collapse and deflate, reverting to the closed formation and blocking secondary airflow 108.

This solution does not require additional mechanical or electronic actuators, instead using the inherent pressure dynamics to maintain airflow integrity. The tube's flexibility and positioning eliminate the need for additional actuation, relying on its natural propensity to control airflow based on the fan's operational status.

### CONCLUSION

The present disclosure described hereinabove has several technical advantages including, but not limited to, the realization of an optimized airflow management system for redundant fans that:
- provide an optimized airflow management system for redundant fans;
- mitigate the issue of air recirculation caused by redundant fans;
- reduce air recirculation by preventing air from the operating fans from being drawn back into the intake due to redundancy openings, thereby improving airflow through the heat sink assembly;
- enhance energy efficiency by reducing the workload on the operating fans;
- potentially lower energy consumption and operational costs; and
- offer cost-effective solutions that can be implemented with minimal additional costs or modifications to the existing STS assembly, leveraging simple mechanical principles.

The foregoing disclosure has been described with reference to the accompanying examples which do not limit the scope and ambit of the disclosure. The description provided is purely by way of example and illustration.

The examples herein and the various features and advantageous details thereof are explained with reference to the non-limiting examples in the following description. Descriptions of well-known components and processing techniques are omitted so as to not unnecessarily obscure the examples herein. The examples used herein are intended merely to facilitate an understanding of ways in which the examples herein may be practiced and to further enable those of skill in the art to practice the examples herein. Accordingly, the examples should not be construed as limiting the scope of the examples herein.

The foregoing description of the specific examples so fully reveal the general nature of the examples herein that others can, by applying current knowledge, readily modify and/or adapt for various applications such specific examples without departing from the generic concept, and, therefore, such adaptations and modifications should and are intended to be comprehended within the meaning and range of equivalents of the disclosed examples. It is to be understood that the phraseology or terminology employed herein is for the purpose of description and not of limitation. Therefore, while the examples herein have been described in terms of preferred examples, those skilled in the art will recognize that the examples herein can be practiced with modification within the scope of the examples as described herein.

Any discussion of materials, devices, articles or the like that has been included in this specification is solely for the purpose of providing a context for the disclosure. It is not to be taken as an admission that any or all of these matters form a part of the prior art base or were common general knowledge in the field relevant to the disclosure as it existed anywhere before the priority date of this application.

While considerable emphasis has been placed herein on the components and component parts of the preferred examples, it will be appreciated that many examples can be made and that many changes can be made in the preferred examples without departing from the principles of the disclosure. These and other changes in the preferred example as well as other examples of the disclosure will be apparent to those skilled in the art from the disclosure herein, whereby it is to be distinctly understood that the foregoing descriptive matter is to be interpreted merely as illustrative of the disclosure and not as a limitation.

Those having skill in the art will recognize that the state of the art has progressed to the point where there is little distinction left between hardware and software implementations of aspects of systems; the use of hardware or software is generally (but not always, in that in certain contexts the choice between hardware and software can become significant) a design choice representing cost vs. efficiency tradeoffs. Those having skill in the art will appreciate that there are various vehicles by which processes and/or systems and/or other technologies described herein can be implemented (e.g., hardware, software, and/or firmware), and that the preferred vehicle will vary with the context in which the processes and/or systems and/or other technologies are deployed. For example, if an implementer determines that speed and accuracy are paramount, the implementer may opt for a mainly hardware and/or firmware vehicle; alternatively, if flexibility is paramount, the implementer may opt for a mainly software implementation; or, yet again alternatively, the implementer may opt for some combination of hardware, software, and/or firmware. Hence, there are several possible vehicles by which the processes and/or devices and/or other technologies described herein may be implemented, none of which is inherently superior to the other in that any vehicle to be utilized is a choice dependent upon the context in which the vehicle will be deployed and the specific concerns (e.g., speed, flexibility, or predictability) of the implementer, any of which may vary. Those skilled in the art will recognize that optical aspects of implementations will typically employ optically-oriented hardware, software, and or firmware.

The foregoing detailed description has set forth various examples of the devices and/or processes via the use of block diagrams, flowcharts, and/or examples. Insofar as such block diagrams, flowcharts, and/or examples contain one or more functions and/or operations, it will be understood by those within the art that each function and/or operation within such block diagrams, flowcharts, or examples can be implemented, individually and/or collectively, by a wide range of hardware, software, firmware, or virtually any combination thereof. In one example, several portions of the subject matter described herein may be implemented via Application Specific Integrated Circuits (ASICs), Field Programmable Gate Arrays (FPGAs), digital signal processors (DSPs), or other integrated formats. However, those skilled in the art will recognize that some aspects of the examples disclosed herein, in whole or in part, can be equivalently implemented in integrated circuits, as one or more computer programs running on one or more computers (e.g., as one or more programs running on one or more computer systems), as one or more programs running on one or more processors (e.g., as one or more programs running on one or more microprocessors), as firmware, or as virtually any combination thereof, and that designing the circuitry and/or writing the code for the software and/or firmware would be well within the skill of one of skill in the art in light of this disclosure. In addition, those skilled in the art will appreciate that the mechanisms of the subject matter described herein are capable of being distributed as a program product in a variety of forms, and that an illustrative example of the subject matter described herein applies regardless of the particular type of signal bearing medium used to actually carry out the distribution. Examples of a signal bearing medium include, but are not limited to, the following: a recordable type medium such as a floppy disk, a hard disk drive, a Compact Disc (CD), a Digital Video Disk (DVD), a digital tape, a computer memory, etc.; and a transmission type medium such as a digital and/or an analog communication medium (e.g., a fiber optic cable, a waveguide, a wired communications link, a wireless communication link, etc.).

In a general sense, those skilled in the art will recognize that the various aspects described herein which can be implemented, individually and/or collectively, by a wide range of hardware, software, firmware, or any combination thereof can be viewed as being composed of various types of "electrical circuitry." Consequently, as used herein "electrical circuitry" includes, but is not limited to, electrical circuitry having at least one discrete electrical circuit, electrical circuitry having at least one integrated circuit, electrical circuitry having at least one application specific integrated circuit, electrical circuitry forming a general purpose computing device configured by a computer program (e.g., a general purpose computer configured by a computer program which at least partially carries out processes and/or devices described herein, or a microprocessor configured by a computer program which at least partially carries out processes and/or devices described herein), electrical circuitry forming a memory device (e.g., forms of random access memory), and/or electrical circuitry forming a communications device (e.g., a modem, communications switch, or optical-electrical equipment). Those having skill in the art will recognize that the subject matter described herein may be implemented in an analog or digital fashion or some combination thereof.

Those having skill in the art will recognize that it is common within the art to describe devices and/or processes in the fashion set forth herein, and thereafter use engineering practices to integrate such described devices and/or processes into data processing systems. That is, at least a portion of the devices and/or processes described herein can be integrated into a data processing system via a reasonable amount of experimentation. Those having skill in the art will recognize that a typical data processing system generally includes one or more of a system unit housing, a video display device, a memory such as volatile and non-volatile memory, processors such as microprocessors and digital signal processors, computational entities such as operating systems, drivers, graphical user interfaces, and applications programs, one or more interaction devices, such as a touch pad or screen, and/or control systems including feedback loops and control motors (e.g., feedback for sensing position and/or velocity; control motors for moving and/or adjusting components and/or quantities). A typical data processing system may be implemented utilizing any suitable commercially available components, such as those typically found in data computing/communication and/or network computing/communication systems.

The herein described subject matter sometimes illustrates different components contained within, or connected with, different other components. It is to be understood that such depicted architectures are merely exemplary, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

Further examples are set out in the clauses below:
1. An apparatus for airflow management, comprising:
   a structure attachable to a fan, the fan capable of directing a primary airflow at least one of into or through a cabinet-based device;
   wherein the structure maintains a closed formation when the fan is not operational, the closed formation configured for obstructing a secondary airflow through the fan, the secondary airflow associated with a direction opposite the primary airflow; and
   wherein the structure is configured to deploy into an open formation when the fan is operational, the open formation configured for allowing the primary airflow through the fan.
2. The apparatus of Clause 1, wherein:
   the fan has an inflow side and an outflow side opposite the inflow side;
   wherein the primary airflow occurs in a direction from the inflow side to the outflow side; and
   wherein the structure is attached to the outflow side of the fan.
3. The apparatus of Clause 1 or 2, wherein:
   the structure comprises a left-side rigid portion and a right-side rigid portion connected by a rigid rear portion;
   wherein the left-side and right-side rigid portions are attached to the fan;
   wherein the rigid rear portion is perpendicular to the left-side and right-side rigid portions;
   wherein each of the left-side and right-side rigid portions includes at least one cutout portion hingedly attached to the left-side rigid portion or the right-side rigid portion respectively;
   wherein the left-side and right-side cutout portions are in a substantially perpendicular orientation to the left-side and right-side rigid portions when the fan is not operational and the structure is in the closed formation;
   and wherein the left-side and right-side cutout portions are in a coplanar orientation to the left-side and right-side rigid portions respectively when the fan is operational and the apparatus is in the open formation;
   wherein the left-side and right-side cutout portions are configured to pivot into the coplanar orientation in response to the primary airflow when the fan is operational and the apparatus is in the open formation.
4. The apparatus of any one of the preceding Clauses, wherein:
   the structure comprises a deformable screen held in the closed formation by at least one of a spring, a cam, or an actuator; and
   wherein the deformable screen is maintained in a folded state when in the closed formation.
5. The apparatus of any one of the preceding Clauses, wherein:
   the structure comprises a deformable screen held in the closed formation by at least one of a spring, a cam, or an actuator;
   wherein the deformable screen is maintained in an expanded state when in the closed formation and the fan is not operational; and
   wherein the deformable screen is configured to contract into the open formation when the fan is operational.
6. The apparatus of any one of the preceding Clauses, wherein:
   the structure is a tubular structure fashioned of a flexible material, the tubular structure attached to the outflow side of the fan;
   wherein the tubular structure is maintained in the closed formation when the fan is not operational; and
   wherein the tubular structure is maintained in the open formation by the primary airflow when the fan is operational.
7. A cabinet-based device, comprising:
   a plurality of fans at least partially disposed within a cabinet, the plurality of fans including at least one primary fan and at least one redundant fan, the at least one redundant fan configured for operation in response to a failure of the at least one primary fan,
   wherein the plurality of fans is configured to direct a primary airflow at least one of into or through the cabinet; and
   a structure attached to at least one fan of the plurality of fans, each structure configured to maintain a closed formation when the associated fan is not operational,
   wherein the closed formation is configured for obstructing a secondary airflow through the associated fan, the secondary airflow in a direction opposite that of the primary airflow, and
   wherein the structure is configured to deploy into an open formation when the associated fan is operational, the open formation configured for allowing the primary airflow through the associated fan.
8. The cabinet-based device of Clause 7, further comprising:
   at least one heat sink;
   wherein the primary airflow into or through the cabinet-based device is directed at least one of over or through the heat sink.
9. The cabinet-based device of Clause 7 or 8, wherein the structure is attached to the at least one redundant fan only.
10. The cabinet-based device of any one of Clauses 7-9, wherein:
   each fan has an inflow side and an outflow side, the outflow side opposite the inflow side and associated with an interior of the cabinet;
   wherein the primary airflow flows from the inflow side to the outflow side; and
   wherein each structure is attached to the outflow side of the associated fan.
11. The cabinet-based device of any one of Clauses 7-10, wherein:
   each structure comprises a left-side rigid portion and a right-side rigid portion connected by a rigid rear portion;
   wherein the left-side and right-side rigid portions are attached to the associated fan;
   wherein the rigid rear portion is perpendicular to the left-side and right-side rigid portions;
   wherein each of the left-side and right-side rigid portions includes at least one cutout portion hingedly attached to the left-side rigid portion or the right-side rigid portion respectively;
   wherein the left-side and right-side cutout portions are in a perpendicular orientation to the left-side and right-side rigid portions when the associated fan is not operational and the structure is in the closed formation;
      and
   wherein the left-side and right-side cutout portions are in a coplanar orientation to the left-side and right-side rigid portions respectively when the associated fan is operational and the structure is in the open formation;
   wherein the left-side and right-side cutout portions are configured to pivot into the coplanar orientation in response to the primary airflow when the associated fan is operational and the structure is in the open formation.
12. The cabinet-based device of any one of Clauses 7-11, wherein:
   the structure comprises a deformable screen held in the closed formation by at least one of a spring, a cam, or an actuator; and
   wherein the deformable screen is maintained in a folded state when in the closed formation.
13. The cabinet-based device of any one of Clauses 7-12, wherein:
   the structure comprises a deformable screen held in the closed formation by at least one of a spring, a cam, or an actuator;
   wherein the deformable screen is maintained in an expanded state when in the closed formation and the associated fan is not operational;
      and
   wherein the deformable screen is configured to contract into the open formation when the associated fan is operational.
14. The cabinet-based device of any one of Clauses 7-13, wherein:
   the structure is a tubular structure fashioned of a flexible material, the tubular structure attached to the outflow side of the associated fan;
   wherein the tubular structure is maintained in the closed formation when the fan is not operational;
   and wherein the tubular structure is maintained in the open formation by the primary airflow when the fan is operational.
While particular aspects of the present subject matter described herein have been shown and described, it will be apparent to those skilled in the art that, based upon the teachings herein, changes and modifications may be made without departing from the subject matter described herein and its broader aspects and, therefore, the appended claims are to encompass within their scope all such changes and modifications as are within the scope of the subject matter described herein.

## Claims

1. An apparatus for airflow management, comprising:
a structure attachable to a fan, the fan capable of directing a primary airflow at least one of into or through a cabinet-based device;
wherein the structure maintains a closed formation when the fan is not operational, the closed formation configured for obstructing a secondary airflow through the fan, the secondary airflow associated with a direction opposite the primary airflow;
and
wherein the structure is configured to deploy into an open formation when the fan is operational, the open formation configured for allowing the primary airflow through the fan.

2. The apparatus of Claim 1, wherein:
the fan has an inflow side and an outflow side opposite the inflow side;
wherein the primary airflow occurs in a direction from the inflow side to the outflow side;
and
wherein the structure is attached to the outflow side of the fan.

3. The apparatus of Claim 1 or 2, wherein:
the structure comprises a left-side rigid portion and a right-side rigid portion connected by a rigid rear portion;
wherein the left-side and right-side rigid portions are attached to the fan;
wherein the rigid rear portion is perpendicular to the left-side and right-side rigid portions;
wherein each of the left-side and right-side rigid portions includes at least one cutout portion hingedly attached to the left-side rigid portion or the right-side rigid portion respectively;
wherein the left-side and right-side cutout portions are in a substantially perpendicular orientation to the left-side and right-side rigid portions when the fan is not operational and the structure is in the closed formation;
and
wherein the left-side and right-side cutout portions are in a coplanar orientation to the left-side and right-side rigid portions respectively when the fan is operational and the apparatus is in the open formation;
wherein the left-side and right-side cutout portions are configured to pivot into the coplanar orientation in response to the primary airflow when the fan is operational and the apparatus is in the open formation.

4. The apparatus of any one of the preceding Claims, wherein:
the structure comprises a deformable screen held in the closed formation by at least one of a spring, a cam, or an actuator;
and
wherein the deformable screen is maintained in a folded state when in the closed formation.

5. The apparatus of any one of the preceding Claims, wherein:
the structure comprises a deformable screen held in the closed formation by at least one of a spring, a cam, or an actuator;
wherein the deformable screen is maintained in an expanded state when in the closed formation and the fan is not operational;
and
wherein the deformable screen is configured to contract into the open formation when the fan is operational.

6. The apparatus of any one of the preceding Claims, wherein:
the structure is a tubular structure fashioned of a flexible material, the tubular structure attached to the outflow side of the fan;
wherein the tubular structure is maintained in the closed formation when the fan is not operational;
and
wherein the tubular structure is maintained in the open formation by the primary airflow when the fan is operational.

7. The apparatus of any one of the preceding Claims, wherein the cabinet-based device comprises a plurality of fans including the fan, the plurality of fans at least partially disposed within a cabinet, the plurality of fans including at least one primary fan and at least one redundant fan, the at least one redundant fan configured for operation in response to a failure of the at least one primary fan,
wherein the plurality of fans is configured to direct a primary airflow at least one of into or through the cabinet.

8. The apparatus of Claim 7, further comprising:
at least one heat sink;
wherein the primary airflow into or through the cabinet-based device is directed at least one of over or through the heat sink.

9. The apparatus of Claim 7 or 8, wherein the structure is attached to the at least one redundant fan only.

10. The apparatus of any one of Claims 7-9, wherein:
each fan has an inflow side and an outflow side, the outflow side opposite the inflow side and associated with an interior of the cabinet;
wherein the primary airflow flows from the inflow side to the outflow side;
and
wherein each structure is attached to the outflow side of the associated fan.

11. The apparatus of any one of Claims 7-10, wherein:
each structure comprises a left-side rigid portion and a right-side rigid portion connected by a rigid rear portion;
wherein the left-side and right-side rigid portions are attached to the associated fan;
wherein the rigid rear portion is perpendicular to the left-side and right-side rigid portions;
wherein each of the left-side and right-side rigid portions includes at least one cutout portion hingedly attached to the left-side rigid portion or the right-side rigid portion respectively;
wherein the left-side and right-side cutout portions are in a perpendicular orientation to the left-side and right-side rigid portions when the associated fan is not operational and the structure is in the closed formation;
and
wherein the left-side and right-side cutout portions are in a coplanar orientation to the left-side and right-side rigid portions respectively when the associated fan is operational and the structure is in the open formation;
wherein the left-side and right-side cutout portions are configured to pivot into the coplanar orientation in response to the primary airflow when the associated fan is operational and the structure is in the open formation.

12. The apparatus of any one of Claims 7-11, wherein:
the structure comprises a deformable screen held in the closed formation by at least one of a spring, a cam, or an actuator;
and
wherein the deformable screen is maintained in a folded state when in the closed formation.

13. The apparatus of any one of Claims 7-12, wherein:
the structure comprises a deformable screen held in the closed formation by at least one of a spring, a cam, or an actuator;
wherein the deformable screen is maintained in an expanded state when in the closed formation and the associated fan is not operational;
and
wherein the deformable screen is configured to contract into the open formation when the associated fan is operational.

14. The apparatus of any one of Claims 7-13, wherein:
the structure is a tubular structure fashioned of a flexible material, the tubular structure attached to the outflow side of the associated fan;
wherein the tubular structure is maintained in the closed formation when the fan is not operational;
and
wherein the tubular structure is maintained in the open formation by the primary airflow when the fan is operational.
